# FASCICULE DE BREVET EUROPEEN

(11) **EP 3 381 057 B1**
(45) Date de publication et mention de la délivrance du brevet: **25.09.2019**
(21) Numéro de dépôt: 16802028.7
(22) Date de dépôt: 25.11.2016
(51) Int. Cl.: H01L 27/146, H01L 31/103

(54) **DISPOSITIF DE PHOTO-DÉTECTION COMPORTANT DES TRANCHÉES À REVÊTEMENT DE GRANDE BANDE INTERDITE ET PROCÉDÉ DE FABRICATION**
FOTODETEKTOR MIT EINER BESCHICHTUNG MIT GRÄBEN MIT BESCHICHTUNG MIT BREITEM BANDABSTAND SOWIE HERSTELLUNGSVERFAHREN
PHOTODETECTION DEVICE HAVING A COATING COMPRISING TRENCHES WITH A WIDE BANDGAP COATING AND PRODUCTION METHOD

(30) Priorité: 27.11.2015 FR 1561487
(43) Date de publication de la demande: 03.10.2018
(73) Titulaire: Commissariat à l'Énergie Atomique et aux Énergies Alternatives, 75015 Paris (FR)
(72) Inventeur: ROTHMAN, Johan, 38000 Grenoble (FR); ROCHETTE, Florent, 38440 Saint Jean de Bournay (FR)
(74) Mandataire: Brevalex
(86) Numéro de dépôt international: PCT/EP2016/078792
(87) Numéro de publication internationale: WO 2017/089527

(56) Documents cités:
- WO-A2-2005/101512
- US-A- 5 602 414
- US-A- 5 880 510
- US-A- 5 952 703

## Description

### DOMAINE TECHNIQUE

Le domaine de l'invention est celui des photo-détecteurs comprenant un réseau de diodes, tel qu'un réseau matriciel, fabriquées sur un substrat semi-conducteur. L'invention a trait plus précisément aux diodes de type p/n ou n/p qui peuvent être utilisées pour des imageurs dans le visible ou dans l'infrarouge.

### ÉTAT DE LA TECHNIQUE ANTÉRIEURE

Dans de nombreuses applications de photo-détection, des diodes sont agencées en matrices de diodes sur un substrat. Dans une matrice, les diodes sont agencées en lignes et en colonnes. Une matrice de diode peut être utilisée pour permettre une détection d'un rayonnement électromagnétique. Il peut en effet se former des paires électrons-trous par interaction entre le rayonnement électromagnétique et le substrat. Cela permet l'apparition d'un courant proportionnel à une intensité du rayonnement incident. Chaque diode forme alors un pixel d'un photo-détecteur.

En venant coupler la matrice de diodes avec un circuit électronique de lecture, il est ainsi possible de capter la variation spatio-temporelle de l'intensité de lumière sur le photo-détecteur. La sensibilité d'un tel photo-détecteur est donnée par sa capacité à traduire des faibles variations spatiales ou temporelles de l'intensité de lumière en un signal comparé utilisable malgré des variations aléatoires (bruit) résultant de phénomènes thermiques et électriques dans les diodes et dans le circuit de lecture.

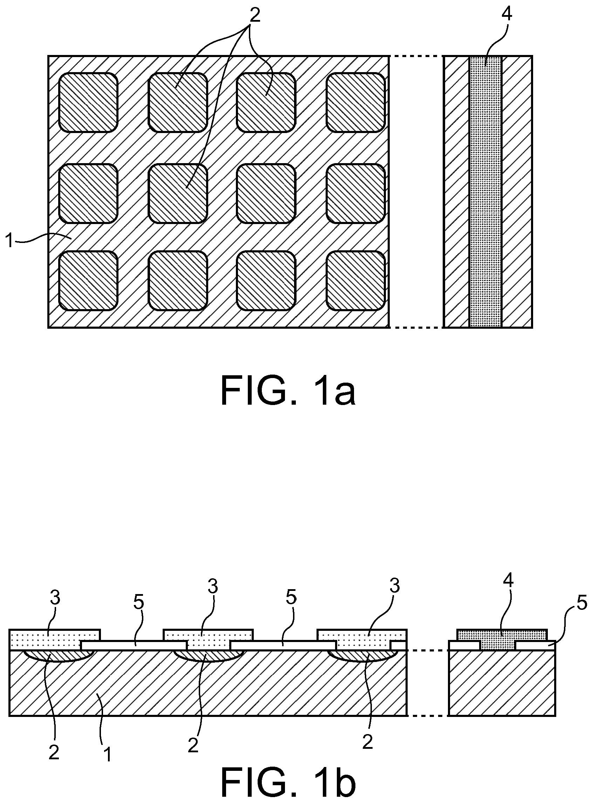

Une telle matrice de diodes est illustrée sur les figures 1a et 1b qui représentent respectivement une vue de dessus et une vue en coupe le long d'une ligne de la matrice. Une diode est formée dans un substrat présentant une couche d'absorption 1 en un matériau semi-conducteur avec une largeur de bande interdite et caractérisé par un type de conductivité. La diode comprend une région de collection 2 de type de conductivité opposé, formant ainsi une jonction p-n.

Comme illustré sur la figure 1b, chaque région de collection est en contact avec un plot métallique 3 formant un contact diode. Une région métallique 4, formée en périphérie de la matrice, est en contact avec le substrat, et forme un contact substrat. Les deux régions de type de conductivité opposé 1, 2 sont protégées d'une dégradation de leurs propriétés chimiques, mécaniques et électroniques au moyen d'une couche de passivation 5 recouvrant la surface du substrat à l'exception des zones de contact diode et de contact substrat.

Dans la région à proximité de l'interface des deux régions de type de conductivité opposé 1, 2 se forme une zone dite de charge espace (ZCE). Cette zone est caractérisée par la présence d'une barrière d'énergie pour les porteurs majoritaires de chaque côté de la jonction. Les photons arrivant dans la couche d'absorption 1 du substrat semi-conducteur peuvent céder leur énergie à un électron. Si l'électron transite entre la bande de valence et la bande de conduction et se déplace jusqu'à la zone de charge d'espace, la charge va être collectée par la région de collection 2. Les charges ainsi collectées peuvent être transférées à un circuit électronique, appelé circuit de lecture, connecté à chaque diode pour disposer d'un signal utilisable. L'extraction de charge est compensée par un appel de charge par le contact substrat qui est, dans le cas généralement utilisé dans l'état de l'art, commun pour l'ensemble des diodes.

Lors de la détection d'un grand flux de photons, chaque diode débite un grand flux de charge, i.e. courant électrique, proportionnel au flux de photon arrivant à proximité de la diode. Les courants de toutes les diodes sont additionnés à travers le substrat jusqu'au contact substrat. En présence d'une résistance électrique dans le substrat, le courant dans celui-ci peut fortement influencer le fonctionnement des diodes.

Cette résistance électrique peut ainsi induire une variation de la polarisation qui altère le fonctionnement des diodes. Dans le cas extrême, elle peut entrainer une annulation du transfert des charges entre les diodes et le circuit de lecture par une diminution de la barrière de potentiel dans les jonctions. Ce phénomène est d'autant plus important que le nombre de diodes et le flux de photons sur la matrice sont importants.

Cette résistance électrique peut par ailleurs fortement ralentir le transfert des charges dans le circuit de lecture, même en présence d'un flux faible, du fait d'un effet RC collectif.

Par ailleurs, le contrôle de l'état de l'interface entre la couche de passivation 5 et les régions semi-conductrices 1, 2 est crucial pour obtenir une sensibilité maximale. Ceci est dû aux défauts qui peuvent être présent à l'interface, mais aussi à des états dans la passivation qui agissent comme des pièges pour les charges. Les défauts à l'interface peuvent ainsi agir comme des centres de génération/recombinaison des porteurs qui diminuent le signal photonique et augmentent la contribution du courant d'origine thermique ou électrique généré dans le substrat et/ou dans la jonction. Les états pièges dans la passivation sont quant à eux susceptibles de faire varier temporellement la densité de charge locale à proximité de chaque piège. Ces fluctuations peuvent à leur tour générer des fluctuations sur le courant photonique et sur les différents courants d'obscurité.

Une autre source de variation temporelle de la performance des diodes correspond à des défauts présents dans les matériaux, tels que des dislocations ou des complexes d'atomes qui génèrent des états d'énergie dans la bande interdite. L'influence de ces défauts dépend de leur emplacement et de leur environnement électrique. La présence de ces défauts n'est pas nécessairement rédhibitoire, mais une modulation de leur emplacement et/ou leur environnement électrique est fortement susceptible de moduler la performance des diodes en induisant des variations de sensibilité et/ou une augmentation du nombre de diodes en défaut. En particulier, l'influence délétère de ces défauts augmente significativement lorsque la température de fonctionnement du photo-détecteur augmente. Par exemple, la gamme de température accessible pour des photo-détecteurs fonctionnant dans l'infra-rouge est aujourd'hui limitée à environ 160K. Au-delà de cette température, la défectuosité devient rédhibitoire pour le bon fonctionnement d'un photo-détecteur haute performance.

Une autre caractéristique importante pour la performance d'un photo-détecteur est la capacité de collecter les photo-porteurs générés dans un pixel dans le même pixel, sans induire un signal sur les pixels voisins (problème de diaphonie électro-optique). Cette caractéristique, mesurée par la fonction d'étalement d'un point (PSF), est cruciale pour réaliser des imageurs avec une taille et un pas de pixel réduits. Dans un imageur réalisé selon l'état de l'art, les charges sont collectées par diffusion (marche aléatoire) et la PSF est dégradée quand le pas de pixel se rapproche de l'épaisseur de la couche d'absorption.

Une technique permettant de réduire cette diaphonie consiste à assurer une séparation physique des pixels en venant graver des tranchées autour des pixels. Chaque pixel forme dans ce cas un mésa. On connaît en particulier de la demande de brevet WO 2005/101512 A2 une gravure de tranchées dans une couche collectrice qui repose sur une couche d'absorption, les tranchées s'étendant jusqu'à la couche d'absorption et les flancs des tranchées présentant un type de conductivité opposé au type de conductivité de la couche conductrice pour en contrôler les propriétés électriques. Le réseau de pixels est cependant sensible à la présence d'une métallisation et/ou aux défauts présents à la surface, et peut donc avoir des défauts en bruit (fluctuants).

Le document US5602414 divulgue un réseau de diodes adjacentes pour la photo-détection d'infrarouge. Les diodes y sont séparées par des tranchées sur les flancs desquels est déposée une couche de stabilisation.

### EXPOSÉ DE L'INVENTION

L'invention a pour objectif d'améliorer la sensibilité d'un photo-détecteur par stabilisation de la performance des diodes, notamment via une réduction des fluctuations spatiales et/ou d'états électriques des défauts présents dans les matériaux et une suppression de la diaphonie électro-optique entre diodes.

A cet effet, l'invention propose un dispositif de photo-détection à réseau de diodes tel que défini dans la revendication 1.

Certains aspects préférés mais non limitatifs de ce dispositif sont les suivants :
- le deuxième type de dopage est un dopage de type P ;
- une tranchée sépare les régions d'absorption des diodes adjacentes et est dénué de contact avec les régions de collection des diodes adjacentes ;
- les régions d'absorption des diodes reposent sur une couche intermédiaire qui présente un même type et un même niveau de dopage que les régions d'absorption et une énergie de bande interdite supérieure à la première énergie de bande interdite des régions d'absorption ;
- la couche de stabilisation s'étend à travers une partie au moins de la couche intermédiaire ;
- il comporte en outre une couche de passivation qui recouvre chaque diode à l'exception de régions de contact d'un plot électriquement conducteur avec une région de collection d'une diode ;
- la couche de stabilisation s'étend depuis les flancs de la tranchée sur une distance donnée en-dessous de la couche de passivation ;
- chaque diode comprend en outre une région localisée au-dessus de la région d'absorption qui présente un même type de dopage que la région d'absorption et une énergie de bande interdite supérieure à celle de la région d'absorption ;
- la région d'absorption d'une diode présente un niveau de dopage inférieur à 5.10¹⁶ at/cm³ ;
- la face extérieure d'une tranchée est recouverte d'une couche de métallisation.

L'invention porte également sur un procédé de fabrication d'un dispositif de photo-détection comportant un réseau de diodes, tel que défini dans la revendication 11.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels, outre les figures 1a et 1b déjà commentées :
- les figures 2a et 2b sont respectivement une vue en coupe et de dessus le long d'une ligne de diodes d'une matrice de diodes conforme à l'invention ;
- les figures 3 et 4 illustrent des variantes de réalisation de l'invention ;
- les figures 5a-5e illustrent une réalisation possible d'un procédé de fabrication d'un dispositif de photo-détection conforme à l'invention.

### EXPOSÉ DÉTAILLÉ DE MODES DE RÉALISATION PARTICULIERS

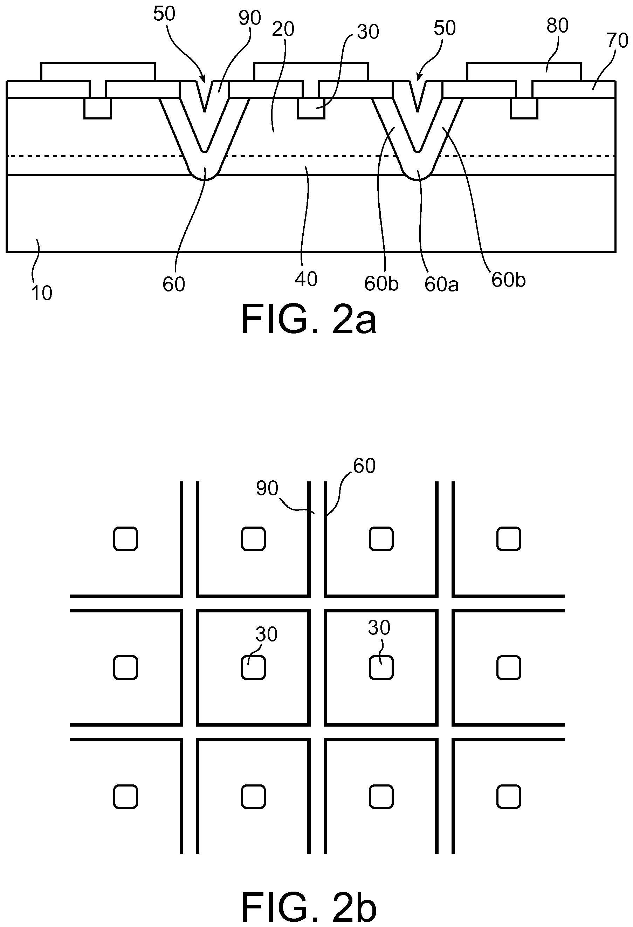

En référence aux figures 2a et 2b, l'invention porte sur un dispositif de photodétection comportant un substrat 10 transparent à la lumière dans la gamme spectrale de détection du dispositif et un réseau de diodes. Chaque diode comprend une région d'absorption 20 portée par le substrat 10 et qui présente une énergie de bande interdite adaptée pour la gamme spectrale de détection. Chaque diode comprend par ailleurs, dans la région d'absorption 20, une région de collection 30 qui présente un premier type de dopage, par exemple un dopage de type N, avec un niveau de dopage typiquement supérieur à 5x10¹⁶ at/cm³.

Les régions d'absorption 20 sont par exemple issues d'une couche d'absorption, par exemple en CdHgTe. Une telle couche peut notamment avoir été formée par épitaxie sur un substrat 10 de CdZnTe. Sa composition en cadmium peut être comprise entre 20 et 40%. Son épaisseur est par exemple comprise entre 2 et 6 µm.

Les régions d'absorption 20 sont de préférence de type N. Mais elles peuvent également être de type P. Leur niveau de dopage est par exemple compris entre 1x10¹⁴ et 5x10¹⁶ at/cm³.

Dans un mode de réalisation possible, les régions d'absorption 20 des diodes reposent sur une couche intermédiaire 40 elle aussi formée par épitaxie en surface du substrat 10. La couche intermédiaire 40 présente un même type et un même niveau de dopage que les régions d'absorption 20 et une énergie de bande interdite supérieure à celle des régions d'absorption, obtenue typiquement au moyen d'une composition en cadmium supérieure à celle des régions d'absorption. La composition en cadmium de la couche intermédiaire 40 peut être constante ou suivre un gradient de composition selon lequel la composition en cadmium diminue jusqu'à atteindre les régions d'absorption 20. L'épaisseur de la couche intermédiaire 40 est par exemple comprise entre 1 et 2 µm.

Toujours en référence aux figures 2a et 2b, dans le réseau de diodes, les diodes adjacentes sont séparées par une tranchée 50 qui comporte des flancs et un fond reliant les flancs. Les tranchées définissent ainsi des pixels en forme de mésa. Elles forment un quadrillage (dans le cas d'un réseau matriciel, un quadrillage en lignes et colonnes qui s'étendent jusqu'à la périphérie de la matrice) venant séparer chacune des diodes adjacentes. Comme représenté sur la figure 2a, une tranchée 50 sépare les régions d'absorption 20 de diodes adjacentes et est dénué de contact avec les régions de collection 30 des diodes adjacentes. Les flancs et le fond d'une tranchée délimitent une face intérieure de la tranchée côté substrat et une face extérieure de la tranchée.

Dans le cadre de l'invention, on retrouve une couche de stabilisation 60 le long de la face intérieure des tranchées. La couche de stabilisation 60 présente un second type de dopage opposé au premier type de dopage des régions de collection 30. Le deuxième type de dopage peut ainsi être de type P. On prévoit par ailleurs que la couche de stabilisation 60 présente une énergie de bande interdite supérieure à celle des régions d'absorption.

Dans un tel dispositif, la présence des tranchées définit un minimum local d'énergie pour des défauts associés à une déformation du réseau cristallin, tels que des dislocations et des agrégats atomiques. La présence de ce genre de défauts, formés lors de la fabrication ou l'utilisation du dispositif (cyclage thermique du produit fini), est ainsi plus probable dans la région au fond des tranchées. La formation de la région de stabilisation à forte bande interdite dans cette région de fond permet de réduire l'amplitude des fluctuations associées avec ces défauts sur les performances du photo-détecteur, et, de ce fait, autorise une stabilisation de la performance de part une réduction du nombre de défauts de bruit.

On retrouve également la couche de stabilisation 60 le long des flancs d'une tranchée. La couche de stabilisation comprend ainsi une portion 60a au niveau du fond des tranchées et des portions 60b le long des flancs des tranchées. L'extension de la couche de stabilisation le long des flancs des tranchées réduit, par le même effet que celui précédemment indiqué, l'impact des défauts générés lors de la formation des tranchées.

La couche de stabilisation 60 peut être issue d'une transformation des flancs et du fond d'une tranchée, réalisée par incorporation (par exemple par implantation) et diffusion d'une impureté (de type accepteur en cas de dopage de type P, par exemple de l'arsenic) à même de conduire à l'obtention d'une région d'énergie de bande interdite supérieure à celles des régions d'absorption, par exemple en venant favoriser une inter-diffusion entre les atomes de Cadmium et de Mercure dans une couche de CdHgTe.

La géométrie des flancs d'une tranchée est de préférence adaptée pour faciliter l'incorporation de l'impureté. Dans le cas d'une implantation de l'impureté, cette géométrie est de préférence caractérisée par des flancs inclinés. Le fond des tranchées peut quant à lui être pointu, arrondi ou rectangulaire.

Prenant l'exemple d'une couche de collection de type N et d'une couche de stabilisation de type P, une jonction N/x/P est formée dans chaque diode.

Lorsque les régions d'absorption présentent un dopage de type n, chaque diode présente une jonction p-n localisée à l'interface entre la région d'absorption 20 et la couche de stabilisation 60 sur les flancs de la tranchée 50 séparant ladite région d'absorption de la région d'absorption de la diode adjacente.

Lorsque les régions d'absorption présentent un dopage de type p, chaque diode présente une jonction p-n localisée à l'interface entre la région de collection 30 et la région d'absorption 20.

Dans un mode de réalisation privilégié de l'invention, la couche de stabilisation 60 s'étend à travers une partie au moins de la couche intermédiaire 40 sous-jacente aux régions d'absorption 20 et d'énergie de bande interdite supérieure aux régions d'absorption 20. De telle manière, les photo-porteurs générés dans la région d'absorption d'une diode sont confinés dans celle-ci et ne peuvent diffuser vers la diode adjacente dont elle est séparée par la tranchée 50. Ce confinement limite la diaphonie électro-optique et ce mode de réalisation est ainsi favorable à la réalisation de photo-détecteurs avec un faible pas de pixel. Dans l'exemple de la figure 2a, la couche de stabilisation 60 traverse intégralement la couche intermédiaire 40 jusqu'à déboucher dans le substrat 10.

Le dispositif selon l'invention peut par ailleurs comporter un contact substrat périphérique agencé sur au moins un côté du réseau de diodes. Ce contact n'est pas représenté sur la figure 2a et 2b mais est similaire à celui discuté précédemment en liaison avec les figures 1a et 1b. Un tel contact substrat périphérique permet de réaliser une connexion électrique entre le substrat et le circuit de lecture sur la périphérie du réseau de diodes libérant ainsi de la place entre les diodes, et permettant avantageusement de réaliser un réseau de diodes avec un faible pas entre les diodes.

Comme représenté sur la figure 2a, le dispositif comprend en outre une couche de passivation 70 qui recouvre le réseau de diodes à l'exception des tranchées 50, de régions de contact d'un plot électriquement conducteur 80 avec une région de collection 30 d'une diode, et le cas échéant d'une région de contact périphérique d'un plot électriquement conducteur avec le substrat.

Les diodes sont ainsi protégées d'une dégradation qui peut être d'origine mécanique, chimique et électrique par la couche de passivation 70. La passivation est ouverte localement au-dessus des régions de collection 30 pour permettre de former des contacts métalliques 80 dans ces régions. Elle peut également, mais non nécessairement, être ouverte au-dessus de la couche de stabilisation 60 des tranchées 50 pour permettre d'y former un contact métallique 90.

Les plots 80 sont localisés au-dessus des régions de collection 30 de chaque pixel. Ces contacts diode 80 permettent de réaliser une connexion électrique individuelle de chaque diode avec un circuit de lecture électronique qui est capable d'assembler l'information issue de chaque pixel.

Comme représenté sur la figures 2a et 2b, chaque couche de stabilisation 60 d'une tranchée peut être recouverte d'une couche de métallisation 90. Cette métallisation formée sur la face extérieure de la tranchée, en contact avec la couche de stabilisation, est distribuée dans et sur les flancs des tranchées jusqu'à la périphérie de la matrice comme représenté sur la figure 2b. Dans une variante de réalisation, la continuité du contact substrat étant assurée par la couche de stabilisation 60, la métallisation 90 peut présenter une rupture de continuité avec le contact substrat en ne venant pas recouvrir la couche de stabilisation par la métallisation 90 à certains endroits, par exemple au niveau de chaque région inter-pixel (au niveau de chaque croisement d'une ligne et d'une colonne sur la figure 2b). L'intérêt de cette variante est de relaxer les contraintes mécaniques induites par un dépôt de métallisation, ces contraintes pouvant conduire à la génération de défauts structuraux et donc être sources de bruit et de courant parasite additionnel. La stabilité des performances ainsi que les performances elles-mêmes sont ainsi améliorées.

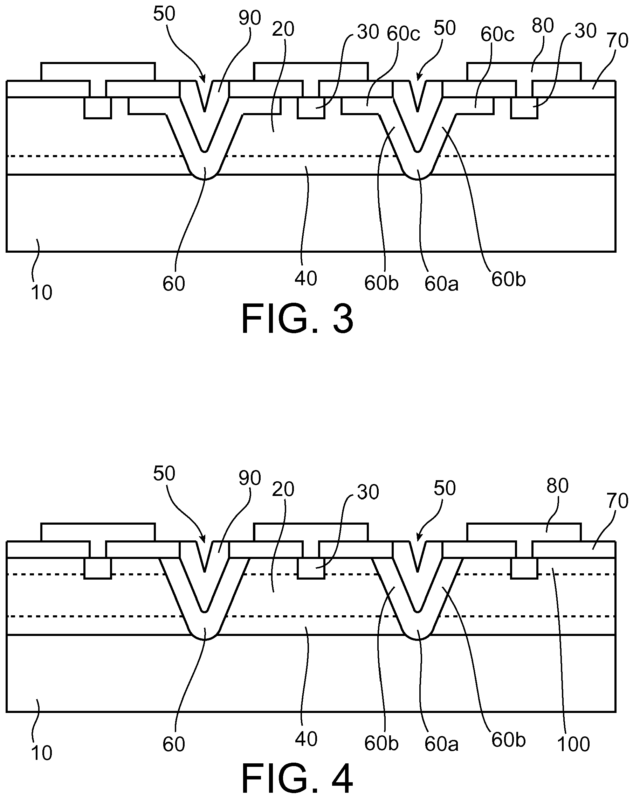

Dans une autre variante de réalisation représentée sur la figure 3, la couche de stabilisation 60 s'étend depuis les flancs de la tranchée sur une distance donnée en-dessous de la couche de passivation 70. En d'autres termes, la couche de stabilisation 60 comprend également des portions 60c s'étendant sous la couche de passivation 70 depuis la partie supérieure des portions 60b formés le long des flancs d'une tranchée. Ces portions 60c sont dimensionnées de manière à ne pas venir en contact avec une région de collection 30, en en étant séparées d'une distance d'au moins 0,5 µm. Cette variante permet de réduire l'influence des défauts situées dans et à proximité de la couche de passivation 70 sur la stabilité de la performance.

Dans une autre variante de réalisation représentée sur la figure 4, compatible avec celle de la figure 3, chaque diode comprend en outre une région 100 localisée au-dessus de la région d'absorption 20 qui présente un même type de dopage que la région d'absorption et une énergie de bande interdite supérieure à celle de la région d'absorption. Cette augmentation de l'énergie de bande interdite au-dessus de la région d'absorption 20 sous la couche de passivation permet de réduire l'influence des défauts sur la performance électro-optique et ainsi d'améliorer la stabilité de la performance de chaque pixel. Dans le cas d'un dopage de type opposé de la couche d'absorption 20 et de la région de collection 30, il est préférable que la région de collection 30 dépasse de cette région 100 de forte bande interdite pour être en contact avec la région d'absorption 20.

La combinaison des deux variantes présentées ci-dessus, permet, en plus d'une amélioration de la stabilité des performances, de réduire la génération d'un courant tunnel dans la zone entre la couche de stabilisation 60 et la région de collection 20, permettant d'accéder à des polarisations inverses plus importantes.

On relèvera que ces deux variantes sont particulièrement avantageuses pour des applications à température de fonctionnement élevée du photo-détecteur (applications dites HOT pour « High Operating Temperature »).

Dans une autre variante de réalisation, les régions 20, et le cas échéant les régions 40 et 100, présentent un niveau de dopage faible, typiquement inférieur à 1x10¹⁵ at/cm³. Une grande partie du volume de ces régions est alors déplété pour de faibles valeurs de polarisation inverse, typiquement inférieures à 1 à 2 V. Cette variante permet de supprimer la contribution des courants de diffusion au courant d'obscurité, qui va être limité au courant dit GR (pour Génération-Recombinaison), généré sur les défauts présents dans la zone de charge d'espace (ZCE) lors de l'application de la polarisation inverse. De plus, cette variante permet de réduire le temps de collection des photo-porteurs, ce qui est favorable à l'obtention d'une sensibilité photonique stabilisée.

L'invention n'est pas limitée au dispositif de photo-détection précédemment décrit, mais s'étend également à un procédé de fabrication d'un dispositif de photo-détection comportant un réseau de diodes, dans lequel chaque diode du réseau comporte une région d'absorption qui présente une première énergie de bande interdite et une région de collection qui présente un premier type de dopage. Le procédé comprend la formation d'une tranchée séparant les diodes adjacentes dans le réseau, et une étape consistant à transformer le fond et les flancs d'une tranchée en une couche de stabilisation présentant un deuxième type de dopage opposé au premier type de dopage et une énergie de bande interdite supérieure à la première énergie de bande interdite des régions d'absorption.

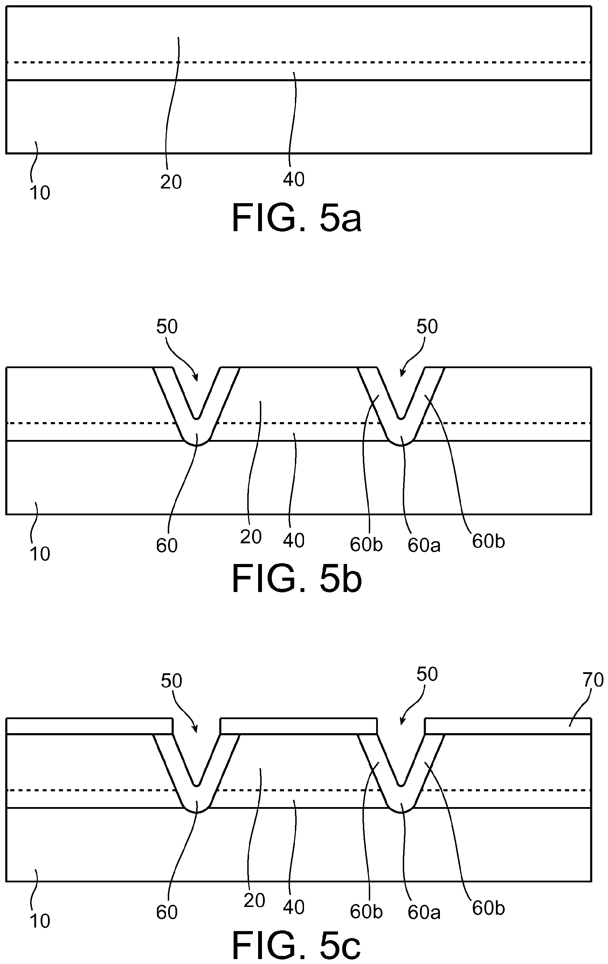

Les figures 5a-5e illustrent un exemple de réalisation d'un tel procédé qui débute (figure 5a) par une étape de fourniture d'un substrat 10 portant la couche intermédiaire 40 et la couche d'absorption 20.

En référence à la figure 5b, on procède ensuite à la gravure des tranchées 50 formant un quadrillage délimitant la région de collection des porteurs de chacune des diodes. La gravure est suffisamment profonde pour que l'impureté implantée à l'étape suivante puisse diffuser jusque dans la couche intermédiaire 40. La gravure est typiquement réalisée jusqu'à atteindre la couche intermédiaire 40, ou s'arrête à pas plus de 1 µm de l'interface entre la couche d'absorption 20 et la couche intermédiaire 40. Les tranchées s'étendent ainsi dans la couche d'absorption pour venir en séparer des régions d'absorption.

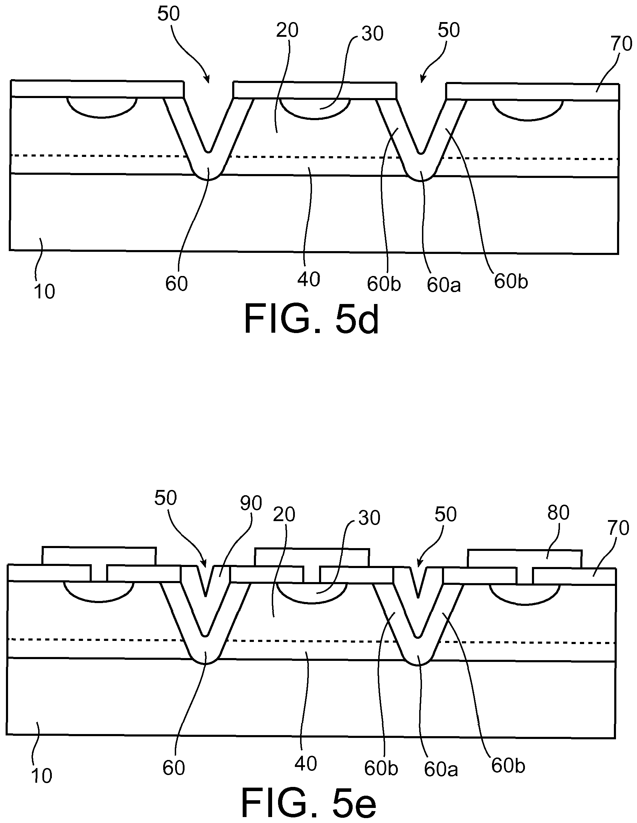

Toujours en référence à la figure 5, on procède ensuite à l'implantation d'une impureté de type accepteur, de préférence As, puis à un recuit d'activation et de diffusion de cette impureté de type accepteur. Le recours à un élément dopant, tel que As ou Sb, favorise l'inter-diffusion de Cd entre les régions afin de former la couche de stabilisation avec un dopage de type P et un gap supérieur à la couche d'absorption 40.

En référence à la figure 5c, on réalise le dépôt d'une couche de passivation 70.

Un recuit sous pression de vapeur saturante de Hg est ensuite mis en oeuvre afin de supprimer les lacunes de Hg. Ce recuit permet de réaliser une inter-diffusion de cadmium dans la couche de passivation 70 et la couche de stabilisation 60. Il est par exemple réalisé à une température supérieure à 400 °C pendant plus d'une heure.

Comme représenté sur la figure 5d, on réalise ensuite la formation d'une région de collection 30 de fort dopage N+, par exemple implantation de Bore, au centre de chaque pixel.

On procède ensuite à l'ouverture de la passivation à la périphérie de la matrice de photodiodes, au niveau des tranchés et au centre de chaque pixel, puis au dépôt d'une couche de métal et à sa gravure pour la conserver au niveau de chaque pixel, au niveau du contact substrat périphérique et au niveau de chaque tranchée. L'épaisseur restante de métal est typiquement inférieure à 1 µm.

L'invention trouve avantageusement application dans les cas suivants :
- imagerie requérant une mise en route rapide ou une utilisation continue sans re-calibration autre que celle faite en sortie d'usine ;
- imagerie à haute température de fonctionnement, grâce à la réduction du nombre de défauts en bruit et à la réduction du courant d'obscurité ;
- imagerie grand format, le quadrillage métallisé permettant en effet d'obtenir une structure n/P avec un très faible effet de dépolarisation ;
- imagerie à faible pas pixel, par la suppression de la diaphonie de diffusion des porteurs entre les pixels.

L'invention peut par ailleurs être utilisée avec un dispositif de concentration optique pour favoriser l'obtention d'un rendement quantique maximal. Dans ce cas, le volume de la région d'absorption peut être minimisé afin de réduire le courant d'obscurité et améliorer la sensibilité et/ou augmenter la température de fonctionnement du détecteur.

## Revendications

1. Dispositif de photo-détection à réseau de diodes, dans lequel chaque diode du réseau comporte une région d'absorption (20) dans une couche d'absorption portée par un substrat (10), la région d'absorption (20) présentant une première énergie de bande interdite, et une région de collection (30) qui présente un premier type de dopage, dans lequel les diodes adjacentes dans le réseau sont séparées par une tranchée (50) comportant des flancs et un fond qui résultent d'une gravure de la couche d'absorption et qui délimitent une face intérieure de la tranchée côté substrat et une face extérieure de la tranchée, et dans lequel une couche de passivation (70) recouvre chaque diode à l'exception des tranchées (50) et de régions de contact d'un plot électriquement conducteur (80) avec une région de collection (20) d'une diode, **caractérisé en ce qu'**il comporte une couche de stabilisation (60) le long de la face intérieure d'une tranchée (50), la couche de stabilisation (60) étant issue d'une transformation des flancs et du fond de la tranchée (50) réalisée par incorporation et diffusion d'une impureté, la couche de stabilisation (60) présentant un deuxième type de dopage opposé au premier type de dopage et une énergie de bande interdite supérieure à la première énergie de bande interdite des régions d'absorption (20).

2. Dispositif selon la revendication 1, dans lequel le deuxième type de dopage est un dopage de type P.

3. Dispositif selon l'une des revendications 1 et 2, dans lequel une tranchée (50) sépare les régions d'absorption des diodes adjacentes et est dénuée de contact avec les régions de collection (30) des diodes adjacentes.

4. Dispositif selon l'une des revendications 1 à 3, dans lequel les régions d'absorption (20) des diodes reposent sur une couche intermédiaire (40) qui présente un même type et un même niveau de dopage que les régions d'absorption et une énergie de bande interdite supérieure à la première énergie de bande interdite des régions d'absorption.

5. Dispositif selon la revendication 4, dans lequel la couche de stabilisation (60) agencée le long de la face intérieure d'une tranchée s'étend à travers une partie au moins de la couche intermédiaire (40) de manière à empêcher la diffusion des porteurs générés dans la région d'absorption d'une diode vers la diode adjacente dont elle est séparée par la tranchée.

6. Dispositif selon l'une des revendications 1 à 5, dans lequel la couche de stabilisation (60) s'étend depuis les flancs de la tranchée sur une distance donnée en-dessous de la couche de passivation (70).

7. Dispositif selon l'une des revendications 1 à 6, dans lequel chaque diode comprend en outre, côté opposé au substrat, une région localisée au-dessus de la région d'absorption qui présente un même type de dopage que la région d'absorption et une énergie de bande interdite supérieure à celle de la région d'absorption.

8. Dispositif selon l'une des revendications 1 à 7, dans lequel la région d'absorption d'une diode présente un niveau de dopage inférieur à 5.10¹⁶ at/cm³.

9. Dispositif selon l'une des revendications 1 à 8, dans lequel la face extérieure d'une tranchée est recouverte d'une couche de métallisation (90).

10. Dispositif selon la revendication 9, dans lequel la couche de métallisation d'une tranchée est en contact électrique avec un contact substrat périphérique agencé sur au moins un côté du réseau de diodes.

11. Procédé de fabrication d'un dispositif de photo-détection comportant un réseau de diodes, dans lequel chaque diode du réseau comporte une région d'absorption dans une couche d'absorption (20) portée par un substrat (10), la région d'absorption présentant une première énergie de bande interdite, et une région de collection qui présente un premier type de dopage, le procédé comprenant la formation de tranchées séparant les diodes adjacentes dans le réseau, chaque tranchée comportant des flancs et un fond qui résultent d'une gravure de la couche d'absorption et qui délimitent une face intérieure de la tranchée côté substrat et une face extérieure de la tranchée, et la formation d'une une couche de passivation (70) qui recouvre chaque diode à l'exception des tranchées (50) et de régions de contact d'un plot électriquement conducteur (80) avec une région de collection (20) d'une diode,
**caractérisé en ce qu'**il comporte une étape de formation d'une couche de stabilisation le long de la face intérieure d'une tranchée qui comprend la transformation du fond et des flancs de la tranchée par incorporation et diffusion d'une impureté, la couche de stabilisation présentant un deuxième type de dopage opposé au premier type de dopage et une énergie de bande interdite supérieure à la première énergie de bande interdite des régions d'absorption.

## Patentansprüche

1. Fotodetektionsvorrichtung mit Diodenarray, wobei jede Diode des Array einen Absorptionsbereich (20) in einer von einem Substrat (10) getragenen Absorptionsschicht enthält, wobei der Absorptionsbereich (20) eine erste Bandlückenenergie aufweist, sowie einen Sammelbereich (30), der eine erste Art von Dotierung aufweist, wobei die benachbarten Dioden in dem Array durch einen Graben (50) mit Flanken und einem Boden getrennt sind, die aus einem Ätzen der Absorptionsschicht resultieren und die eine Innenfläche des Grabens auf der Substratseite und eine Außenfläche des Grabens begrenzen, und wobei eine Passivierungsschicht (70) jede Diode mit Ausnahme von den Gräben (50) und von Kontaktbereichen eines elektrisch leitfähigen Kontaktstücks (80) mit einem Sammelbereich (20) einer Diode bedeckt, **dadurch gekennzeichnet, dass** sie eine Stabilisierungsschicht (60) entlang der Innenfläche eines Grabens (50) enthält, wobei die Stabilisierungsschicht (60) sich aus einer Bearbeitung der Flanken und des Bodens des Grabens (50) durch Einarbeitung und Diffusion einer Verunreinigung ergibt, wobei die Stabilisierungsschicht (60) eine der ersten Art der Dotierung entgegengesetzte zweite Art der Dotierung und eine Bandlückenenergie aufweist, die höher ist als die erste Bandlückenenergie der Absorptionsbereiche (20).

2. Vorrichtung nach Anspruch 1,
wobei die zweite Art der Dotierung eine p-Dotierung ist.

3. Vorrichtung nach einem der Ansprüche 1 und 2,
wobei ein Graben (50) die Absorptionsbereiche der benachbarten Dioden trennt und keinen Kontakt mit den Sammelbereichen (30) der benachbarten Dioden hat.

4. Vorrichtung nach einem der Ansprüche 1 bis 3,
wobei die Absorptionsbereiche (20) der Dioden auf einer Zwischenschicht (40) aufliegen, die die gleiche Art von Dotierung und den gleichen Dotierungsgrad wie die Absorptionsbereiche und eine Bandlückenenergie aufweist, die höher ist als die erste Bandlückenenergie der Absorptionsbereiche.

5. Vorrichtung nach Anspruch 4,
wobei die entlang der Innenfläche eines Grabens angeordnete Stabilisierungsschicht (60) sich durch zumindest einen Teil der Zwischenschicht (40) so erstreckt, dass sie die Diffusion der Träger, die in dem Absorptionsbereich einer Diode erzeugt werden, von einer Diode zur benachbarten Diode verhindert, von welcher sie durch den Graben getrennt ist.

6. Vorrichtung nach einem der Ansprüche 1 bis 5,
wobei die Stabilisierungsschicht (60) sich ausgehend von den Flanken des Grabens über eine gegebene Entfernung unterhalb der Passivierungsschicht (70) erstreckt.

7. Vorrichtung nach einem der Ansprüche 1 bis 6,
wobei jede Diode ferner auf der dem Substrat entgegengesetzten Seite einen oberhalb des Absorptionsbereichs befindlichen Bereich enthält, der die gleiche Art von Dotierung wie der Absorptionsbereich und eine Bandlückenenergie aufweist, die höher als die des Absorptionsbereichs ist.

8. Vorrichtung nach einem der Ansprüche 1 bis 7,
wobei der Absorptionsbereich einer Diode einen Dotierungsgrad von unter 5.10¹⁶ at/cm³ aufweist.

9. Vorrichtung nach einem der Ansprüche 1 bis 8,
wobei die Außenfläche eines Grabens mit einer Metallisierungsschicht (90) überdeckt ist.

10. Vorrichtung nach Anspruch 9,
wobei die Metallisierungsschicht eines Grabens elektrisch mit einem umlaufenden Substratkontakt in Kontakt steht, der auf zumindest einer Seite des Diodenarray angeordnet ist.

11. Verfahren zum Herstellen einer Fotodetektionsvorrichtung mit einem Diodenarray, wobei jede Diode des Array einen Absorptionsbereich in einer von einem Substrat (10) getragenen Absorptionsschicht (20) enthält, wobei der Absorptionsbereich (20) eine erste Bandlückenenergie aufweist, sowie einen Sammelbereich, der eine erste Art von Dotierung aufweist, wobei das Verfahren das Ausbilden von Gräben umfasst, welche die benachbarten Dioden in dem Array trennen, wobei jeder Graben Flanken und einen Boden aufweist, die aus einem Ätzen der Absorptionsschicht resultieren und die eine Innenfläche des Grabens auf der Substratseite und eine Außenfläche des Grabens begrenzen, sowie das Ausbilden einer Passivierungsschicht (70), die jede Diode mit Ausnahme von den Gräben (50) und von Kontaktbereichen eines elektrisch leitfähigen Kontaktstücks (80) mit einem Sammelbereich (20) einer Diode bedeckt,
**dadurch gekennzeichnet, dass** es einen Schritt des Ausbildens einer Stabilisierungsschicht entlang der Innenfläche eines Grabens umfasst, welcher das Bearbeiten des Bodens und der Flanken des Grabens durch Einarbeitung und Diffusion einer Verunreinigung umfasst, wobei die Stabilisierungsschicht eine der ersten Art der Dotierung entgegengesetzte zweite Art der Dotierung und eine Bandlückenenergie aufweist, die höher ist als die erste Bandlückenenergie der Absorptionsbereiche.

## Claims

1. Photodetection device with an array of diodes, wherein each diode of the array includes an absorption region (20) in an absorption layer carried by a substrate (10), the absorption region (20) having a first bandgap energy, and a collection region (30) which has a first doping type, wherein the adjacent diodes in the array are separated by a trench (50) including flanks and a bottom which result from an etching of the absorption layer and which delimit an internal face of the trench on the substrate side and an external face of the trench, and wherein a passivation layer (70) covers each diode except for the trenches (50) and contact regions of an electrically conductive stud (80) with a collection region (20) of a diode, **characterised in that** it includes a stabilisation layer (60) along the internal face of a trench (50), the stabilisation layer (60) resulting from a transformation of the flanks and of the bottom of the trench (50) made by incorporating and diffusing an impurity, the stabilisation layer (60) having a second doping type opposite to the first doping type and a bandgap energy higher than the first bandgap energy of the absorption regions (20).

2. Device according to claim 1, wherein the second doping type is a P type doping.

3. Device according to one of claims 1 and 2, wherein a trench (50) separates the absorption regions from the adjacent diodes and is devoid of contact with the collection regions (30) of the adjacent diodes.

4. Device according to one of claims 1 to 3, wherein the absorption regions (20) of the diodes rest on an intermediate layer (40) which has a same doping type and a same doping level as the absorption regions and a bandgap energy higher than the first bandgap energy of the absorption regions.

5. Device according to claim 4, wherein the stabilisation layer (60) arranged along the internal face of a trench extends through at least one part of the intermediate layer (40) so as to prevent carriers generated in the absorption region of a diode from being diffused to the adjacent diode from which it is separated therefrom by the trench.

6. Device according to one of claims 1 to 5, wherein the stabilisation layer (60) extends from the flanks of the trench on a given distance underneath the passivation layer (70).

7. Device according to one of claims 1 to 6, wherein each diode further comprises, on the opposite side to the substrate, a region located above the absorption region which has a same doping type as the absorption region and a bandgap energy higher than that of the absorption region.

8. Device according to one of claims 1 to 7, wherein the absorption region of a diode has a doping level lower than 5.10¹⁶ at/cm³.

9. Device according to one of claims 1 to 8, wherein the external face of a trench is covered with a metallisation layer (90).

10. Device according to claim 9, wherein the metallisation layer of a trench is in electric contact with a peripheral substrate contact arranged on at least one side of the array of diodes.

11. Method for manufacturing a photodetection device including an array of diodes, wherein each diode of the array includes an absorption region in an absorption layer (20) carried by a substrate (10), the absorption region having a first bandgap energy, and a collection region which has a first doping type, the method comprising forming trenches separating the adjacent diodes in the array, each trench including flanks and a bottom which result from an etching of the absorption layer and which delimit an internal face of the trench on the substrate side and an external face of the trench, and forming a passivation layer (70) which covers each diode except for the trenches (50) and contact regions of an electrically conductive stud (80) with a collection region (20) of a diode,
**characterised in that** it includes a step of forming a stabilisation layer along the internal face of a trench which comprises transforming the bottom and the flanks of the trench by incorporating and diffusing an impurity, the stabilisation layer having a second doping type opposite to the first doping type and a bandgap energy higher than the first bandgap energy of the absorption regions.
